(19) Europäisches Patentamt
European Patent Office
Office européen des brevets

(11) EP 4 383 986 A1

(12) EUROPEAN PATENT APPLICATION

(43) Date of publication:
12.06.2024 Bulletin 2024/24

(21) Application number: 23213976.6

(22) Date of filing: 04.12.2023

(51) International Patent Classification (IPC):
H10K 59/80 (2023.01)          H10K 59/122 (2023.01)

(52) Cooperative Patent Classification (CPC):
H10K 59/122; H10K 59/873; H10K 59/875;
H10K 59/878

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 07.12.2022 KR 20220169752

(71) Applicant: Samsung Display Co., Ltd.
Yongin-si, Gyeonggi-do 17113 (KR)

(72) Inventors:
• Son, Juyoun
  17113 Yongin-si, Gyeonggi-do (KR)

• Kim, Sang-Ho
  17113 Yongin-si, Gyeonggi-do (KR)
• Baek, Soomin
  17113 Yongin-si, Gyeonggi-do (KR)
• Lee, Jiwon
  17113 Yongin-si, Gyeonggi-do (KR)
• Lee, Cheonmyeong
  17113 Yongin-si, Gyeonggi-do (KR)
• Kim, Bekhyun
  17113 Yongin-si, Gyeonggi-do (KR)
• Ha, Juhwa
  17113 Yongin-si, Gyeonggi-do (KR)

(74) Representative: Gulde & Partner
Patent- und Rechtsanwaltskanzlei mbB
Wallstraße 58/59
10179 Berlin (DE)

(54) DISPLAY DEVICE

(57) A display device includes pixel electrodes (PXE1, PXE2) spaced apart from each other, a first definition layer (DL1) defining reflective openings (RO1, RO2, RO3, RO4) opening a first area of each of the pixel electrodes (PXE1, PXE2), reflective electrodes (LEE1, LEE2) disposed on the first area of each of the pixel electrodes (PXE1, PXE2), extending from the first area of each of the pixel electrodes (PXE1, PXE2) to the first definition layer (DL1), and spaced apart from each other, a second definition layer (DL2) disposed on the first definition layer (DL1) and defining pixel openings (PO1, PO2, PO3, PO4) opening a second area of each of the reflective electrodes (LEE1, LEE2), light emitting layers (EL1, EL2) disposed on the second area of each of the reflective electrodes (LEE1, LEE2) within the pixel openings (PO1, PO2, PO3, PO4), a common electrode (CE) overlapping the light emitting layers (EL1, EL2) and the second definition layer (DL2) in plan view, an encapsulation layer (EN) overlapping the common electrode (CE) in plan view, a capping layer (CPL) disposed on the encapsulation layer (EN), and a low refractive index layer (RL) disposed on the capping layer (CPL).

FIG. 7

## Description

BACKGROUND

1. Technical Field

Embodiments relate to a display device for implementing virtual reality (VR) or augmented reality (AR).

2. Description of the Related Art

Recently, a display device that provides virtual reality or augmented reality, such as a head mounted display (HMD), is emerging. To this end, the display device may include a display panel that displays an image and a lens disposed between the display panel and a user.

The display panel may include pixels that emit lights of various colors. In case that light emitted from one pixel having a first color is mixed with light emitted from another pixel having a second color different from the first color, the display quality of the display device may deteriorate, and fatigue of the user using the display device may increase.

SUMMARY

Embodiments provide a display device with improved display quality.

A display device according to embodiments of the disclosure may include a plurality of pixel electrodes spaced apart from each other, a first definition layer defining a plurality of reflective openings exposing a first area of each of the plurality of pixel electrodes, a plurality of reflective electrodes disposed on the first area of each of the plurality of pixel electrodes, extending from the first area of each of the plurality of pixel electrodes to the first definition layer, and spaced apart from each other, a second definition layer disposed on the first definition layer and defining a plurality of pixel openings exposing a second area of each of the plurality of reflective electrodes, a plurality of light emitting layers disposed on the second area of each of the plurality of reflective electrodes within the plurality of pixel openings, a common electrode overlapping the plurality of light emitting layers and the second definition layer in a plan view, an encapsulation layer overlapping the common electrode in the plan view, a capping layer disposed on the encapsulation layer, and a low refractive index layer disposed on the capping layer.

In an embodiment, a refractive index of the low refractive index layer may be lower than a refractive index of the capping layer.

In an embodiment, the refractive index ($N_{RL}$) of the low refractive index layer and the refractive index ($N_{CPL}$) of the capping layer may satisfy the equation $0 < N_{CPL} - N_{RL} \leq 0.1$.

In an embodiment, the display device may further include a plurality of lens portions disposed on the low refractive index layer and overlapping the plurality of reflective openings in the plan view and may further include a bank disposed on the low refractive index layer and partitioning the plurality of lens portions.

In an embodiment, an upper surface of each of the plurality of lens portions may have a convex curved shape in a direction from the encapsulation layer toward the low refractive index layer.

In an embodiment, the bank may be spaced apart from each of the plurality of reflective openings and the plurality of pixel openings in the plan view.

In an embodiment, a cross-sectional width of the bank gradually may decrease in a direction away from an upper surface of the low refractive index layer.

In an embodiment, a contact angle between a side surface of the bank and the upper surface of the low refractive index layer may be in a range of about 45 degrees to about 90 degrees.

In an embodiment, the display device may further include a light blocking pattern disposed on the encapsulation layer, overlapping the bank in the plan view, and including a light blocking material.

In an embodiment, the low refractive index layer may define a plurality of transmission openings corresponding to the plurality of pixel openings.

Alternatively, a display device according to embodiments of the disclosure include a plurality of pixel electrodes spaced apart from each other, a first definition layer defining a plurality of reflective openings opening a first area of each of the plurality of pixel electrodes, a plurality of reflective electrodes disposed on the first area of each of the plurality of pixel electrodes, extending from the first area of each of the plurality of pixel electrodes to the first definition layer, and spaced apart from each other, a second definition layer disposed on the first definition layer and defining a plurality of pixel openings opening a second area of each of the plurality of reflective electrodes, a plurality of light emitting layers disposed on the second area of each of the plurality of reflective electrodes within the plurality of pixel openings, a common electrode overlapping the plurality of light emitting layers and the second definition layer in a plan view, an encapsulation layer overlapping the common electrode in the plan view, and a low refractive index layer disposed on the encapsulation layer.

In an embodiment, the encapsulation layer may include a first encapsulation layer overlapping the common electrode in the plan view and including an inorganic insulating material, a second encapsulation layer overlapping the first encapsulation layer in the plan view and including an organic insulating material, and a third encapsulation layer overlapping the second encapsulation layer in the plan view and including an inorganic insulating material.

In an embodiment, a refractive index of the low refractive index layer may be lower than a refractive index of the third encapsulation layer.

In an embodiment, the refractive index ($N_{RL}$) of the low refractive index layer and the refractive index ($N_{NE3}$) of the third encapsulation layer may satisfy the equation $0 < N_{NE3} - N_{RL} \leq 0.1$.

In an embodiment, the display device may further include a capping layer disposed on the low refractive index layer.

In an embodiment, the display device may further include a plurality of lens portions disposed on the capping layer and overlapping the plurality of reflective openings in the plan view and may further include a bank disposed on the capping layer and partitioning the plurality of lens portions.

A display device according to embodiments of the disclosure include a pixel electrode including a first pixel electrode and a second pixel electrode spaced apart from the first pixel electrode, a first definition layer defining a first reflective opening exposing a first area of the first pixel electrode and a second reflective opening exposing a first area of the second pixel electrode, a reflective electrode including a first reflective electrode disposed on the first area of the first pixel electrode and a second reflective electrode disposed on the first area of the second pixel electrode, a second definition layer defining a first pixel opening exposing a second area of the first reflective electrode and a second pixel opening exposing a second area of the second reflective electrode, a light emitting layer including a first light emitting layer disposed on the second area of the first reflective electrode and a second light emitting layer disposed on the second area of the second reflective electrode, a common electrode overlapping the plurality of light emitting layers and the second definition layer in a plan view, an encapsulation layer overlapping the common electrode in plan view, a capping layer disposed on the encapsulation layer, and a low refractive index layer disposed on the capping layer.

In an embodiment, a refractive index of the low refractive index layer may be lower than a refractive index of the capping layer.

In an embodiment, the refractive index ($N_{RL}$) of the low refractive index layer and the refractive index ($N_{CPL}$) of the capping layer may satisfy the equation $0 < N_{CPL} - N_{RL} \leq 0.1$.

In an embodiment, an area of the first reflective opening may be greater than an area of the first pixel opening in a plan view, and an area of the second reflective opening may be greater than an area of the second pixel opening in the plan view.

In an embodiment, the first reflective electrode may further extend from on the first area of the first pixel electrode to on the first definition layer adjacent to the first area of the first pixel electrode to define a first extension portion, the second reflective electrode may further extend from on the first area of the second pixel electrode to on the first definition layer adjacent to the first area of the second pixel electrode to define a second extension portion, and the first reflective electrode and the second reflective electrode may be spaced apart from each other.

In an embodiment, the first extension portion may surround the first reflective opening in the plan view, and the second extension portion may surround the second reflective opening in the plan view.

In an embodiment, a level of an edge of the first extension portion surrounding the first reflective opening may be higher than a level of an upper surface of the first light emitting layer in a cross-sectional view, and a level of an edge of the second extension portion surrounding the second reflective opening may be higher than a level of an upper surface of the second light emitting layer in the cross-sectional view.

In an embodiment, the second definition layer may be disposed between the first extension portion and the first light emitting layer, and between the second extension portion and the second light emitting layer, and the second definition layer may include a transparent organic material.

In an embodiment, the display device may further include a spacer disposed between the first pixel opening and the second pixel opening in a plan view, and disposed between the second definition layer and the common electrode in a cross-sectional view.

In an embodiment, the spacer may include a light blocking material.

In an embodiment, the display device may further include a lens portion disposed on the low refractive index layer and including a first lens portion overlapping the first reflective opening in the plan view and a second lens portion overlapping the second reflective opening in the plan view and a bank disposed on the low refractive index layer and partitioning the first lens portion and the second lens portion.

In an embodiment, an area of the first lens portion may be greater than an area of the first reflective opening in the plan view, and an area of the second lens portion may be greater than an area of the second reflective opening in the plan view.

A display device according to embodiments of the disclosure may include a plurality of light emitting layers disposed on a second area of each of a plurality of reflective electrodes in a plurality of pixel openings, an encapsulation layer overlapping the plurality of light emitting layers in a plan view, a capping layer overlapping the encapsulation layer in the plan view, and a low refractive index layer disposed on the capping layer. Accordingly, light having a relatively wide viewing angle among the light emitted from the plurality of light emitting layers may be totally reflected at the interface between the capping layer and the low refractive index layer, so that light having different color emitted from the plurality of light emitting layers may not be mixed.

A display device according to another embodiment of the disclosure may include a plurality of light emitting layers disposed on a second area of each of a plurality of reflective electrodes in a plurality of pixel openings, an encapsulation layer overlapping the plurality of light emitting layers in a plan view, and a low refractive index layer disposed on the encapsulation layer. Accordingly, light having a relatively wide viewing angle among the light emitted from the plurality of light emitting layers may be totally reflected at the interface between the encapsulation layer and the low refractive index layer, so that light having different color emitted from the plurality of light emitting layers may not be mixed.

A display device according to another embodiment of the disclosure may include a light emitting layer including a first light emitting layer disposed on a second area of a first reflective electrode and a second light emitting layer disposed on a second area of a second reflective electrode, an encapsulation layer overlapping the light emitting layer in a plan view, a capping layer disposed on the encapsulation layer, and a low refractive index layer disposed on the capping layer. Accordingly, light having a relatively wide viewing angle among the light emitted from the light emitting layer may be totally reflected at the interface between the capping layer and the low refractive index layer, so that the light emitted from the first light emitting layer and the second light emitting layer may not be mixed.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

BRIEF DESCRIPTION OF THE DRAWINGS

Illustrative, non-limiting embodiments will be more clearly understood from the following detailed description in conjunction with the accompanying drawings.

FIG. 1 is a schematic plan view of a display area of a display device according to a first embodiment of the disclosure.
FIG. 2 is a schematic cross-sectional view taken along line I-I' of FIG. 1.
FIGS. 3, 4, 5, 6, and 7 are schematic views of the display device of FIG. 1.
FIG. 8 is a schematic cross-sectional view of a display device according to a second embodiment of the disclosure.
FIG. 9 is a schematic cross-sectional view of a display device according to a third embodiment of the disclosure.
FIG. 10 is a schematic cross-sectional view of a display device according to a fourth embodiment of the disclosure.
FIG. 11 is a schematic cross-sectional view of a display device according to a fifth embodiment of the disclosure.
FIG. 12 is a schematic cross-sectional view of a display device according to a sixth embodiment of the disclosure.
FIG. 13 is a schematic cross-sectional view of a display device according to a seventh embodiment of the disclosure.

DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

The term "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

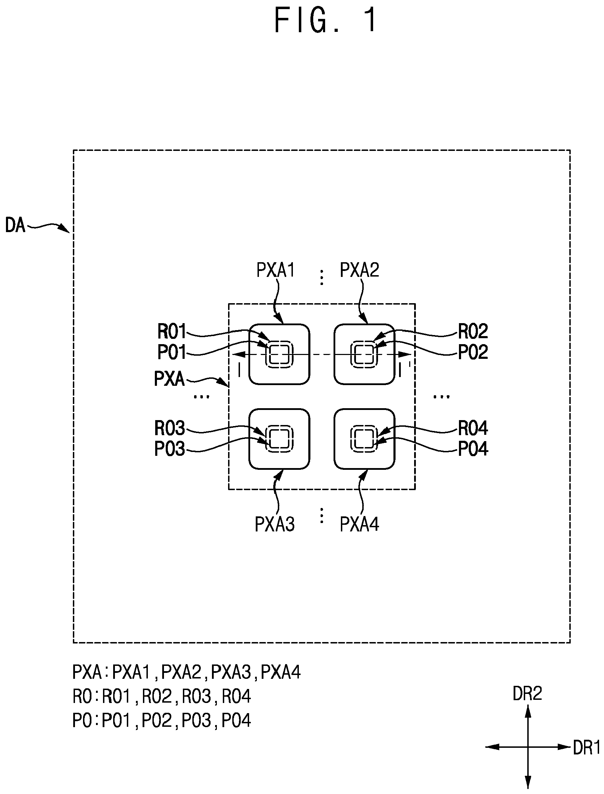

FIG. 1 is a schematic plan view of a display area of a display device according to a first embodiment of the disclosure.

Referring to FIG. 1, a display area DA may be an area where an image is displayed. The display area DA may be divided into unit display area PXA. The unit display area PXA may be an area where light having various colors for displaying an image may be emitted, and may be provided in plural within the display area DA. The multiple unit display areas may completely fill the display area DA and may not overlap and/or may not be far apart from each other. For example, the unit display areas may be repeatedly arranged in a first direction DR1 and a second direction DR2 crossing (intersecting) the first direction DR1 within the display area DA.

In an embodiment, the unit display area PXA may include first to n-th display areas defined as areas from which light is emitted (n may be a natural number greater than or equal to 3). For example, the unit display area PXA may include a first display area PXA1, a second display area PXA2, a third display area PXA3, and a fourth display area PXA4. Each of the first display area PXA1, the second display area PXA2, the third display area PXA3, and the fourth display area PXA4 may be an area where light is substantially emitted, and the user of the display device may view an image displayed by combining light emitted from each of the first display area PXA1, the second display area PXA2, the third display area PXA3, and the fourth display area PXA4.

In an embodiment, light having various colors may be emitted from the first through n-th display areas. For example, light viewed as blue by the user of the display device may be emitted from the first display area PXA1, light viewed as green by the user of the display device may be emitted from each of the second and third display areas PXA2 and PXA3, and light viewed as blue by the user of the display device may be emitted from the fourth display area PXA4.

In an embodiment, the first to nth display areas may have various arrangements in a plan view. For example, the first display area PXA1 and the second display area PXA2 may be arranged in the first direction DR1, and the first display area PXA1 and the third display area PXA3 may be arranged in the second direction DR2, and the third display area PXA3 and the fourth display area PXA4 may be arranged in the first direction DR1.

In an embodiment, the first to nth display regions may have substantially the same or different areas (or shapes) in the plan view. For example, each of the first display area PXA1, the second display area PXA2, the third display area PXA3, and the fourth display area PXA4 may have substantially the same area (or shape) in the plan view. As described later, each display area (PXA1, PXA2, PXA3, PXA4) may include reflective openings RO (RO1, RO2, RO3, RO4) and pixel openings PO (PO1, PO2, PO3, PO4).

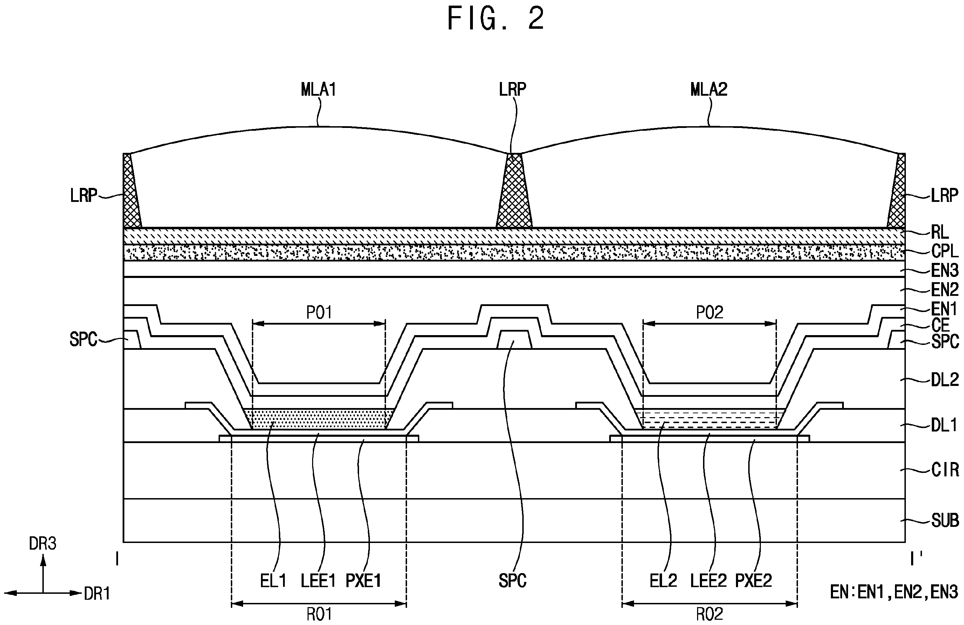

In an embodiment, in case that virtual reality or augmented reality is implemented using the display device, a distance from the display area DA to the user's eyes of the display device may be relatively short. The light emitted from the first to n-th display areas may need to have a relatively narrow viewing angle. For example, light emitted from the first to n-th display areas may have a viewing angle in a range of about 0 degrees to about 45 degrees. Here, the fact that the light emitted from the first to n-th display areas has a viewing angle in a range of about 0 degrees to about 45 degrees may mean that the angle between the traveling path of the light emitted from the first to n-th display area and a direction (e.g., DR3 of FIG. 2) perpendicular the first direction DR1 and the second direction DR2 is in a range of about 0 degrees to about 45 degrees.

FIG. 2 is a schematic cross-sectional view taken along line I-I' of FIG. 1. In FIG. 2, for convenience of description, only cross sections of the first display area PXA1 and the second display area PXA2 of FIG. 1 are shown, but cross sections of the third and fourth display areas PXA3 and PXA4 may also have structures substantially the same as (or similar to) the cross sections of the first and second display areas PXA1 and PXA2.

Referring to FIGS. 1 and 2, the display device may include a substrate SUB, a circuit layer CIR, a first pixel electrode PXE1, a second pixel electrode PXE2, a first definition layer DL1, a first pixel electrode PXE1, a reflective electrode LEE1, a second reflective electrode LEE2, a second definition layer DL2, a first light emitting layer EL1, a second light emitting layer EL2, a spacer SPC, a common electrode CE, an encapsulation layer EN, a capping layer CPL, a low refractive index layer RL, a first lens portion MLA1, a second lens portion MLA2, and a partition wall or bank LRP.

The substrate SUB may include glass or plastic. In an embodiment, at least a portion of the substrate SUB may be bent.

The circuit layer CIR may be disposed on the substrate SUB. The circuit layer CIR may include at least one transistor and at least one insulating layer. For example, the circuit layer CIR may include a first driving transistor electrically connected to the first pixel electrode PXE1 and that provides a first driving current to the first pixel electrode PXE1 and a second driving transistor electrically connected to the second pixel electrode PXE2 and that provides a second driving current to the second pixel electrode PXE2.

The first pixel electrode PXE1 and the second pixel electrode PXE2 may be disposed on the circuit layer CIR. The first pixel electrode PXE1 and the second pixel electrode PXE2 may be spaced apart from each other.

In an embodiment, each of the first pixel electrode PXE1 and the second pixel electrode PXE2 may be referred to as an anode electrode.

Each of the first pixel electrode PXE1 and the second pixel electrode PXE2 may include a conductive material.

For example, each of the first pixel electrode PXE1 and the second pixel electrode PXE2 may include silver, an alloy containing silver, titanium, an alloy containing titanium, molybdenum, an alloy containing molybdenum, aluminum, an alloy containing aluminum, tungsten, tungsten nitride, copper, indium tin oxide, indium zinc oxide, and/or the like. These may be used alone or in combination with each other. Each of the first pixel electrode PXE1 and the second pixel electrode PXE2 may have a single-layer or multi-layer structure including at least one of the above materials.

The first definition layer DL1 may be disposed on the circuit layer CIR. Multiple openings may be defined in the first definition layer DL1, and thus, a part of the first pixel electrode PXE1 and a part of the second pixel electrode PXE2 may be exposed. For example, the first definition layer DL1 may define a first reflective opening RO1 opening a part of the first pixel electrode PXE1 and a second reflective opening RO2 opening a part of the second pixel electrode PXE2.

The first definition layer DL1 may include an organic insulating material. For example, the first definition layer DL1 may include at least one of acrylic resin, methacrylic resin, polyisoprene, vinyl resin, epoxy resin, urethane resin, cellulose resin, siloxane resin, polyimide resin, polyamide resin, and parylene-based resin.

The first reflective electrode LEE1 may be disposed on a part of the first pixel electrode PXE1 within the first reflective opening RO1. The first reflective electrode LEE1 may extend from on the part of the first pixel electrode PXE1 to on the first definition layer DL1 adjacent to the part of the first pixel electrode PXE1 to define a first extension portion. The first extension portion may surround the first reflective opening RO1 in the plan view.

Similarly, the second reflective electrode LEE2 may be disposed on the part of the second pixel electrode PXE2 within the second reflective opening RO2. The second reflective electrode LEE2 may extend from on the part of the second pixel electrode PXE2 to on the first definition layer DL1 adjacent to the part of the second pixel electrode PXE2 to define a second extension portion. The second extension portion may surround the second reflective opening RO2 in the plan view. The second extension portion and the first extension portion may be spaced apart from each other. For example, the second reflective electrode LEE2 may be spaced apart from the first reflective electrode LEE1.

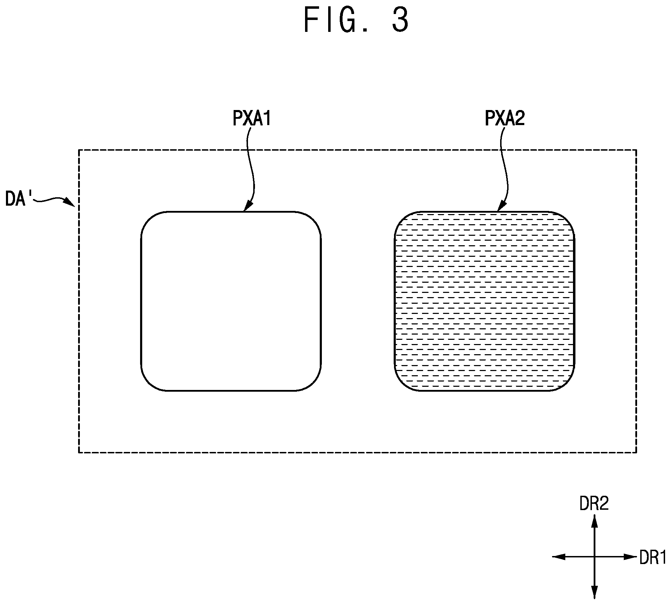

Each of the first reflective electrode LEE1 and the second reflective electrode LEE2 may include a conductive material having a relatively high light reflectance. For example, each of the first reflective electrode LEE1 and the second reflective electrode LEE2 may include a metal material having relatively high light reflectivity and relatively high electrical conductivity. Accordingly, the first reflective electrode LEE1 and the second reflective electrode LEE2 may provide the first driving current and the second driving current provided from the first pixel electrode PXE1 and the second pixel electrode PXE2 to the first light emitting layer EL1 and the second light emitting layer EL2. Each of the first reflective electrode LEE1 and the second reflective electrode LEE2 may serve to improve light emission efficiency of light emitted from each of the first light emitting layer EL1 and the second light emitting layer EL2 to be described later. This will be described later with reference to FIGS. 3 to 5.

The second definition layer DL2 may be disposed on the first definition layer DL1. Multiple openings may be defined in the second definition layer DL2, and thus, a part of the first reflective electrode LEE1 and a part of the second reflective electrode LEE2 may be exposed. For example, the second definition layer DL2 may define a first pixel opening PO1 opening the part of the first reflective electrode LEE1 and a second pixel opening PO2 opening the part of the second reflective electrode LEE2.

The area of the first pixel opening PO1 may be smaller than the area of the first reflective opening RO1 in the plan view, and the first pixel opening PO1 may completely overlap a part of the first reflective opening RO1 in the plan view. For example, the first pixel opening PO1 may be surrounded by the first reflective opening RO1 in the plan view. Similarly, the area of the second pixel opening PO2 may be smaller than the area of the second reflective opening RO2 in the plan view, and the second pixel opening PO2 may be surrounded by the second reflective opening RO2.

The second definition layer DL2 may include an organic insulating material having a relatively high light transmittance. Accordingly, light emitted from the first light emitting layer EL1 and light emitted from the second light emitting layer EL2 may pass through the second definition layer DL2.

The first light emitting layer EL1 may be disposed on the part of the first reflective electrode LEE1 within the first pixel opening PO1. Similarly, the second light emitting layer EL2 may be disposed on the part of the second reflective electrode LEE2 within the second pixel opening PO2.

Each of the first light emitting layer EL1 and the second light emitting layer EL2 may include an organic light emitting layer. For example, the first light emitting layer EL1 may include a first organic light emitting layer that emits light that is viewed as blue light by the user of the display device, and the second light emitting layer EL2 may include a second organic light emitting layer that emits light that is viewed as green light by the user of the display device.

The spacer SPC may be disposed on the second definition layer DL2. The spacer SPC may serve to support a mask used to deposit the light emitting layer while the deposition process of the first light emitting layer EL1 or the second light emitting layer EL2 is in progress. To this end, the spacer SPC may be disposed between two adjacent pixel openings. For example, the spacer SPC may be disposed between the first pixel opening PO1 and the second pixel opening PO2.

The common electrode CE may cover the spacer SPC, the second definition layer DL2, the first light emitting layer LEE1 and the second light emitting layer LEE2. In an embodiment, the common electrode CE may be referred to as a cathode electrode. The common electrode CE may include a transparent conductive material.

The encapsulation layer EN may cover the common electrode CE. The encapsulation layer EN may serve to protect the common electrode CE, the first light emitting layer EL1, the second light emitting layer EL2, the first reflective electrode LEE1, and the second reflective electrode LEE2, the first pixel electrode PXE1, and the second pixel electrode PXE2 from being exposed to external moisture and gas by covering the common electrode CE.

In an embodiment, the encapsulation layer EN may include a first encapsulation layer EN1, a second encapsulation layer EN2, and a third encapsulation layer EN3. The first encapsulation layer EN1 may include an inorganic insulating material and may cover the common electrode CE. The second encapsulation layer EN2 may include an organic insulating material and may be disposed on the first encapsulation layer EN1. An upper surface of the second encapsulation layer EN2 may be substantially flat. The third encapsulation layer EN3 may include an inorganic insulating material and may be disposed on the second encapsulation layer EN2.

The capping layer CPL may be disposed on the encapsulation layer EN. The capping layer CPL may cover the encapsulation layer EN so as to prevent the encapsulation layer EN from being damaged by an external impact or the like.

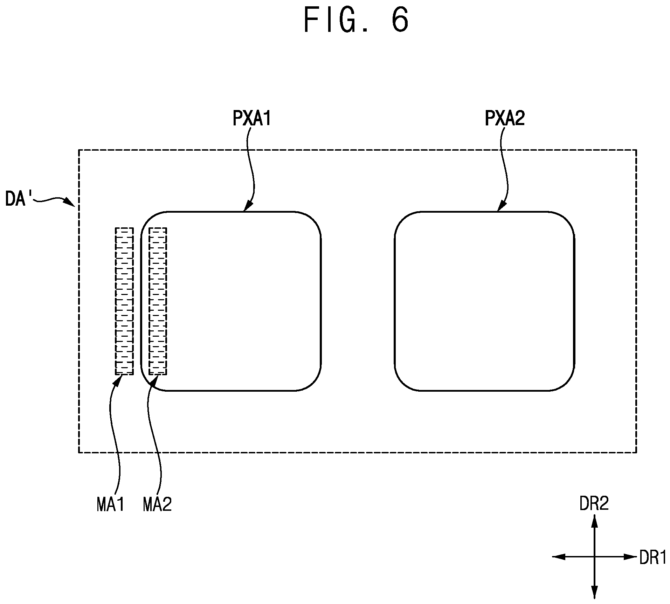

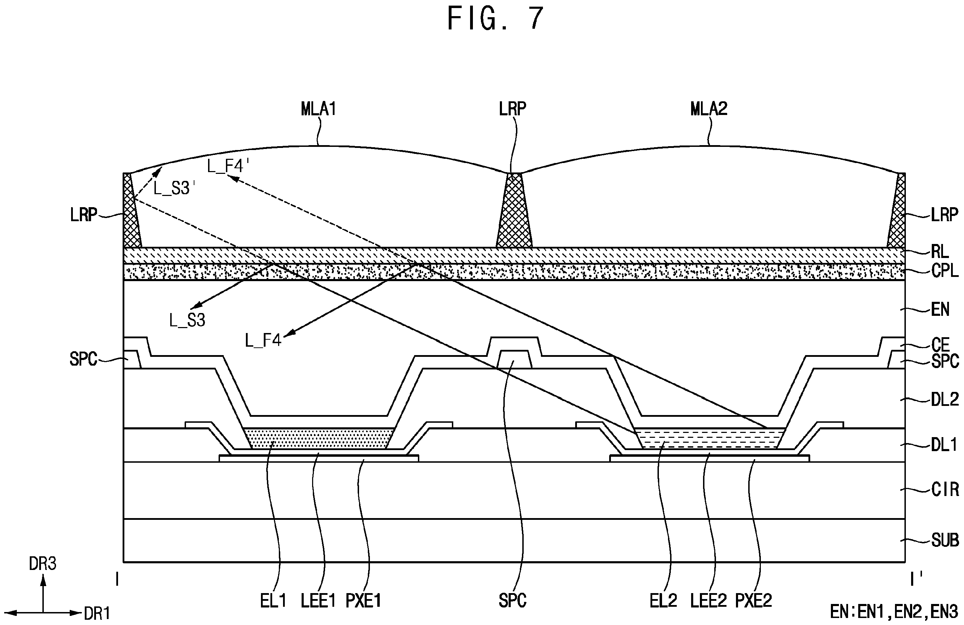

The low refractive index layer RL may be disposed on the capping layer CPL. The low refractive index layer RL may have a relatively low refractive index compared to the capping layer CPL. Accordingly, the low refractive index layer RL may prevent light having different colors from mixing. This will be described later with reference to FIGS. 6 and 7.

The first lens portion MLA1, the second lens portion MLA2, and the bank LRP may be disposed on the low refractive index layer RL.

The first lens portion MLA1 and the second lens portion MLA2 may condense the light emitted from the first light emitting layer EL1 and the second light emitting layer EL2, respectively, so that light passing through the first lens portion MLA1 and the second lens portion MLA2 may have a relatively narrow viewing angle. To this end, each of the upper surface of the first lens portion MLA1 and the upper surface of the second lens portion MLA2 may have a convex curved shape in a direction (e.g., the third direction DR3 perpendicular the first direction DR1 and the second direction DR2) from the encapsulation layer EN toward the low refractive index layer RL.

In order to condense a relatively large amount of light, the first lens portion MLA1 may have a relatively large area in the plan view. For example, the first lens portion MLA1 may overlap the first reflective opening RO1 in the plan view, and the area of the first lens portion MLA1 may be greater than the area of the first reflection aperture RO1 in the plan view. Similarly, the second lens portion MLA2 may overlap the second reflective opening RO2 in the plan view, and the area of the second lens portion MLA2 may be greater than the area of the second reflective aperture RO2 in the plan view.

The bank LRP may partition the first lens portion MLA1 and the second lens portion MLA2. The bank LRP may be spaced apart from each of the first reflective opening RO1 and the second reflective opening RO2 in the plan view, and the width of the bank LRP may gradually decrease in a direction away from th upper surface of the low refractive index layer RL.

For example, as shown in FIG. 2, the bank LRP may have a regular taper shape with respect to the upper surface of the low refractive index layer RL. However, the disclosure is not limited thereto, and the side surface of the bank LRP may have a curved shape in a cross-section. The bank LRP may serve to improve light emission efficiency of light emitted from each of the first light emitting layer EL1 and the second light emitting layer EL2. This will be described later with reference to FIGS. 3 to 5.

FIGS. 3, 4, 5, 6, and 7 are schematic views of the display device of FIG. 1.

FIGS. 3 to 5 are views for explaining light emitted from a light emitting layer of a display area DA' and passed through a lens portion to be viewed by a user of the display device. For convenience of explanation, light emitted from the second light emitting layer EL2 and passed through the second lens portion MLA2 will be described based on light viewed by the user of the display device, and that no light is emitted from the first light emitting layer EL1 is assumed for this explanation.

Referring to FIGS. 3 to 5, light emitted from the second light emitting layer EL2 may pass through the second lens portion MLA2. A user of the display device may view light passing through the second lens portion MLA2 in the entire second display area PXA2.

The upper surface of the second lens portion MLA2 may be convex in the third direction DR3, and thus light emitted from the second light emitting layer EL2 may pass through the second lens portion MLA2 and may have a relatively narrow viewing angle. For example, light passing through the second lens portion MLA2 may have a viewing angle in a range of about 0 degrees to about 45 degrees. Here, light passing through the second lens portion MLA2 has a viewing angle in a range of about 0 degrees to about 45 degrees may mean that the angle between the traveling direction of the light passing through the second lens portion MLA2 and the third direction DR3 is in a range of about 0 degrees to about 45 degrees.

The bank LRP, whose width gradually decreases in a direction away from the upper surface of the low refractive index layer RL, may reflect (or scatter) light emitted from the second light emitting layer EL2 to have a relatively wide viewing angle, the light reflected (or scattered) by the bank LRP and passing through the second lens portion MLA2 may have a relatively narrow viewing angle. For example, in case that the bank LRP has the above-described shape, light emitting efficiency of light emitted from the second light emitting layer EL2 may be improved. In order to maximize the improvement in light emitting efficiency, the contact angle between the side surface of the bank LRP and the upper surface of the low refractive index layer LRP may be in a range of about 45 degrees to about 90 degrees.

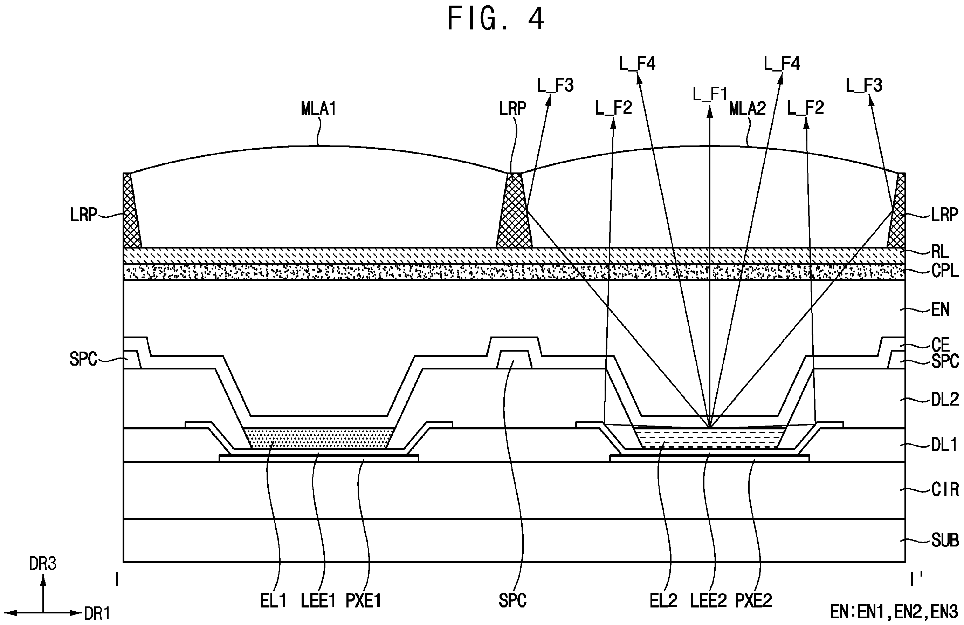

Referring to FIG. 4, light may be emitted from the upper surface of the second light emitting layer EL2. Light emitted from the upper surface of the second light emitting layer EL2 may be emitted at various angles with respect to the upper surface of the second light emitting layer EL2.

In an embodiment, the second light emitting layer EL2 may emit light traveling along a first path L_F1 substantially perpendicular to the upper surface of the second light emitting layer EL2. The first path L_F1 may be a path substantially parallel to the third direction DR3. The light traveling through the first path L_F1 may be viewed by the user of the display device in the second display area PXA2 by passing through the capping layer CPL, the low refractive index layer RL, and the second lens portion MLA2.

In an embodiment, the second light emitting layer EL2 may emit light traveling along a second path L_F2 having a relatively small angle with the upper surface of the second light emitting layer EL2. Light traveling through the second path L_F2 may pass through the capping layer CPL, the low refractive index layer RL, and the second lens portion MLA2 by being reflected by the second reflective electrode LEE2. Accordingly, light traveling along the second path L_F2 may be viewed by the user of the display device in the second display area PXA2.

To this end, as shown in FIG. 4, a level of an edge of the second extension portion of the second reflective electrode LEE2 may be higher than a level of the upper surface of the second light emitting layer EL2. In case that the level of the edge of the second extension portion of the second reflective electrode LEE2 is smaller than or substantially equal to the level of the upper surface of the second light emitting layer EL2, light emitted to form a relatively small angle with the upper surface of the second light emitting layer EL2 may not be reflected by the second reflective electrode LEE2. For example, since the level of the edge of the second extension portion of the second reflective electrode LEE2 is higher than the level of the upper surface of the second light emitting layer EL2, light traveling along the second path L_F2 may be viewed by the user of the display device in the second display area PXA2, and thus light emitting efficiency of the display device may be improved.

In an embodiment, the second light emitting layer EL2 may emit light traveling through the third and fourth paths L_F3 and L_F4 having an angle formed with the upper surface of the second light emitting layer EL2 that is greater than an angle of light traveling through the second path L_F2 and smaller than an angle of light traveling through the first path L_F1. The light traveling through the third path L_F3 may have a smaller angle with the upper surface of the second light emitting layer EL2 than the light traveling along the fourth path L_F4.

Light traveling through the third path L_F3 may pass through the capping layer CPL and the low refractive index layer RL, and may be reflected (or scattered) at the interface between the bank LRP and the second lens portion MLA2. Accordingly, light traveling along the third path L_F3 may be viewed by the user of the display device in the second display area PXA2.

The light traveling through the fourth path L_F4 may be viewed by the user of the display device in the second display area PXA2 by passing through the capping layer CPL, the low refractive index layer RL, and the second lens portion MLA2.

Light viewed by the user of the display device in the second display area PXA2 by traveling through the first, second, third, and fourth paths L_F1, L_F2, L_F3, and L_F4 may have a relatively narrow viewing angle. For example, light traveling through the first, second, third, and fourth paths L_F1, L_F2, L_F3, and L_F4 may have a viewing angle in a range of about 0 degrees to about 45 degrees.

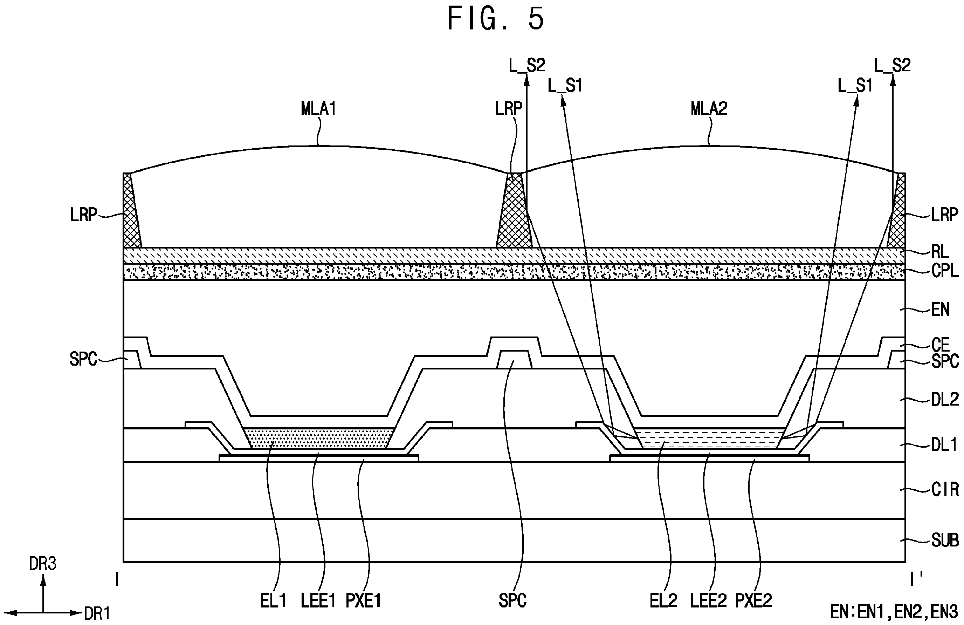

Referring to FIG. 5, light emitted from the side surface of the second light emitting layer EL2 may be viewed by the user of the display device in the second display area PXE2 by being reflected by the second reflective electrode LEE2. More specifically, between the side surface of the second light emitting layer EL2 and the second extension portion extending from the second reflective electrode LEE2 to on the first definition layer DL1, the second definition layer DL2 having a relatively high light transmittance may be disposed, Accordingly, light emitted from the side surface of the second light emitting layer EL2 may be viewed by the user of the display device by being reflected by the second extension portion of the second reflective electrode LEE2. Light emitted from the side surface of the second light emitting layer EL2 and reflected by the second reflective electrode LEE2 and transmitted through the second lens unit MLA2 may have a relatively narrow viewing angle.

In an embodiment, light emitted from the side surface of the second light emitting layer EL2 may be reflected by the second reflective electrode LEE2 and proceed to a first side path L_S1 passing through the capping layer CPL, the low refractive index layer RL, and the second lens portion MI,A2 in sequence.

In an embodiment, light emitted from the side surface of the second light emitting layer EL2 may be sequentially reflected from the second reflective electrode LEE2 and the interface between the bank LRP and the second lens portion MLA2, and may proceed to a second side path L_S2 passing through the second lens portion MLA2.

FIGS. 6 and 7 are views for explaining light emitted from the light emitting layer but not viewed by a user of the display device. For convenience of description, light emitted from the second light emitting layer EL2 is described as a standard, and that no light is emitted from the first light emitting layer EL1 is assumed for this discussion.

Referring to FIGS. 6 and 7, light emitted from the second light emitting layer EL2 to have a relatively wide viewing angle may travel in a direction toward the first lens portion MLA1.

Assuming that there is no low refractive index layer RL, light emitted from the second light emitting layer EL2 to have a relatively wide viewing angle may be viewed by the user of the display device in the first display area PXA1 or an area adjacent to the first display area PXA1.

For example, in case that the low refractive index layer RL is not present, light emitted from the upper surface of the second light emitting layer EL2 to have a relatively wide viewing angle may pass through the capping layer CPL and proceed to a fourth transmission path L_4F' which is a path to the first lens portion MLA1. Accordingly, the light traveling through the fourth transmission path L_F4' may be viewed in a first area MA1 adjacent to the first display area PXA1 or in a second area MA2 within the first display area PXA1. This may cause display defects (e.g., color mixture of light, and the like).

As another example, in case that the low refractive index layer RL is not present, light emitted from the side surface of the second light emitting layer EL2 to have a relatively wide viewing angle may pass through the capping layer CPL, be reflected by the bank LRP, and proceed to the third side transmission path L_S3'. Accordingly, light traveling through the third side transmission path L_S3' may be viewed in the first area MA1 or the second area MA2, and may cause display defects.

In the disclosure, the low refractive index layer RL may be present on the capping layer CPL, and the refractive index of the low refractive index layer RL may be smaller than the refractive index of the capping layer CPL. Accordingly, light emitted from the second light emitting layer EL2 having a relatively wide viewing angle may pass through the capping layer CPL and be totally reflected at the interface between the capping layer CPL and the low refractive index layer RL, and may not be viewed in the first area MA1 or the second area MA2.

For example, light emitted from the upper surface of the second light emitting layer EL2 to have a relatively wide viewing angle may pass through the capping layer CPL, be totally reflected at the interface between the capping layer CPL and the low refractive index layer RL, and proceed to the fourth path L_F4.

As another example, light emitted from the side surface of the second light emitting layer EL2 to have a relatively wide viewing angle may pass through the capping layer CPL, be totally reflected at interface between the capping layer CPL and the low refractive index layer RL, and proceed to the third lateral path L_S3.

In an embodiment, in order to minimize the display defect, the refractive index ($N_{RL}$) of the low refractive index layer RL may be smaller than the refractive index ($N_{CPL}$) of the capping layer CPL, and at the same time, a difference between the refractive index ($N_{RL}$) of the low refractive index layer RL and the refractive index ($N_{CPL}$) of the capping layer CPL may be about 0.1 or less.

In an embodiment, among the lights emitted from the second light emitting layer EL2, the light (e.g., light having an angle of about 62.5 degrees or more with the third direction DR3) causing the display defect may be light emitted at a viewing angle of about 62.5 degrees or more. Accordingly, the refractive index ($N_{RL}$) of the low refractive index layer RL and the refractive index ($N_{CPL}$) of the capping layer CPL may satisfy Equation 1 below in order to totally reflect the light causing the display defect:

$$[\text{Equation 1}]$$

$$N_{CPL} \leq N_{RL} \cdot \sin 62.5^{\circ}$$

In an embodiment, the spacer SPC may include a light blocking material. Accordingly, the spacer SPC may have a relatively high light absorption rate and absorb light emitted from the second light emitting layer EL2 to have a relatively wide viewing angle, thereby preventing the occurrence of the display defect.

In FIGS. 6 and 7, for convenience of description, that the first area MA1 and the second area MA2 where the display defect occurs is assumed, but this is an example, and the area where the display defect occurs is not limited to the first area MA1 and the second area MA2.

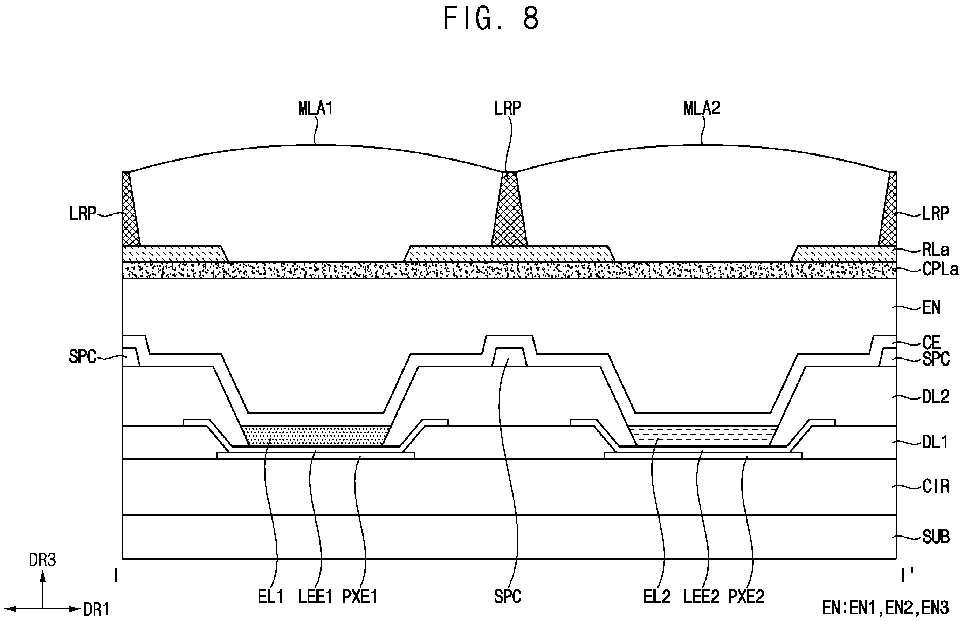

FIG. 8 is a schematic cross-sectional view of a display device according to a second embodiment of the disclosure. Descriptions of overlapping contents with those described with reference to FIGS. 1 to 7 may be omitted.

Referring to FIG. 8, multiple transmission openings may be defined in a low refractive index layer RLa disposed on a capping layer CPLa. For example, a first transmission opening corresponding to the first pixel area PO1 and a second transmission opening corresponding to the second pixel area PO2 may be defined in the low refractive index layer RLa.

The first transmission opening may overlap the first pixel area PO1 in the plan view. The area of the first transmission opening may be equal to or greater than the area of the first pixel region PO1 in the plan view. Similarly, the second transmission opening may overlap the second pixel area PO2 in the plan view. An area of the second transmission opening may be equal to or greater than an area of the second pixel region PO2 in the plan view.

Accordingly, light having a relatively narrow viewing angle among light emitted from the first light emitting layer EL1 and light (e.g., light traveling through the first path L_F1 and the fourth path L_F4 in FIG. 4) having a relatively narrow viewing angle among light emitted from the second light emitting layer EL2 may pass through the capping layer CPLa and proceed directly the first lens portion MLA1 and the second lens portion MLA2 (i.e., not pass through the low refractive index layer RLa). Accordingly, light emitting efficiency may be improved.

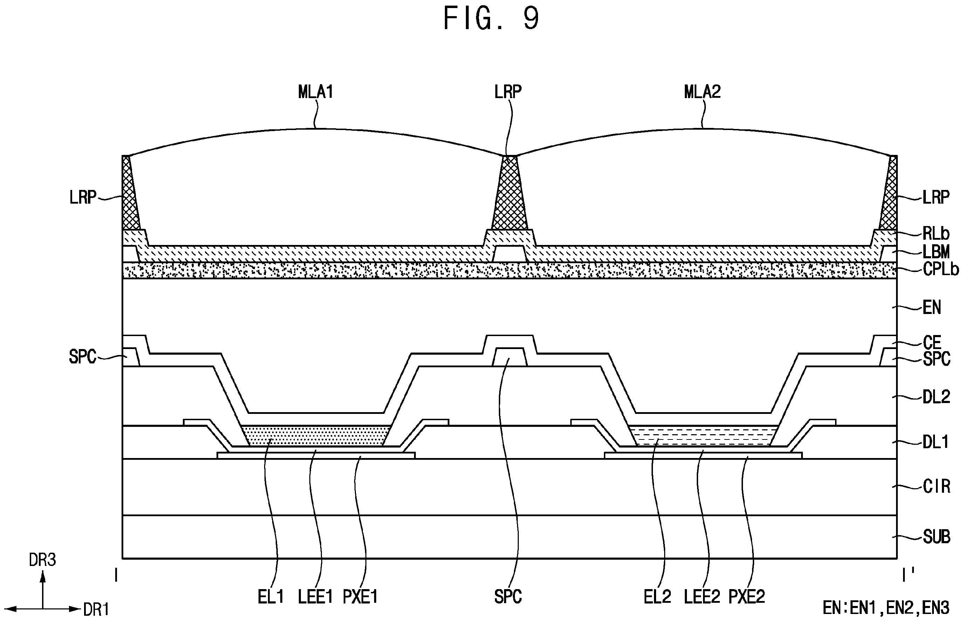

FIG. 9 is a schematic cross-sectional view of a display device according to a third embodiment of the disclosure. Descriptions of overlapping contents with those described with reference to FIGS. 1 to 7 may be omitted.

Referring to FIG. 9, a light blocking pattern LBM including a light blocking material may be disposed between a low refractive index layer RLb and a capping layer CPLb. The light blocking pattern LBM may be disposed overlapping the bank LRP.

The light blocking pattern LBM may block light emitted from the first light emitting layer EL1 and proceeding to the second lens portion MI,A1 and/or light emitted from the second light emitting layer EL2 and traveling to the first lens portion MLA2. Accordingly, the display defect may not occur.

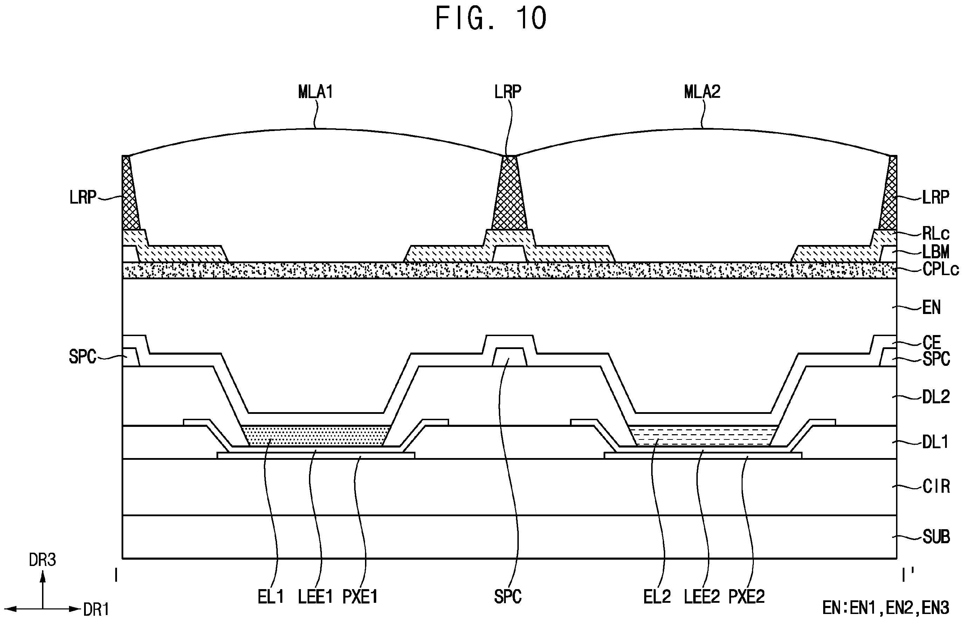

FIG. 10 is a schematic cross-sectional view of a display device according to a fourth embodiment of the disclosure. Descriptions of overlapping contents with those described with reference to FIGS. 1 to 7 may be omitted.

Referring to FIG. 10, a first transmission opening corresponding to the first pixel area PO1 and a second transmission opening corresponding to the second pixel area PO2 may be defined in a low refractive index layer RLc. A light blocking pattern LBM including a light blocking material may be disposed between the low refractive index layer RLc and a capping layer CPLc.

Accordingly, light emitting efficiency may be improved, and at the same time, the display defect may not occur.

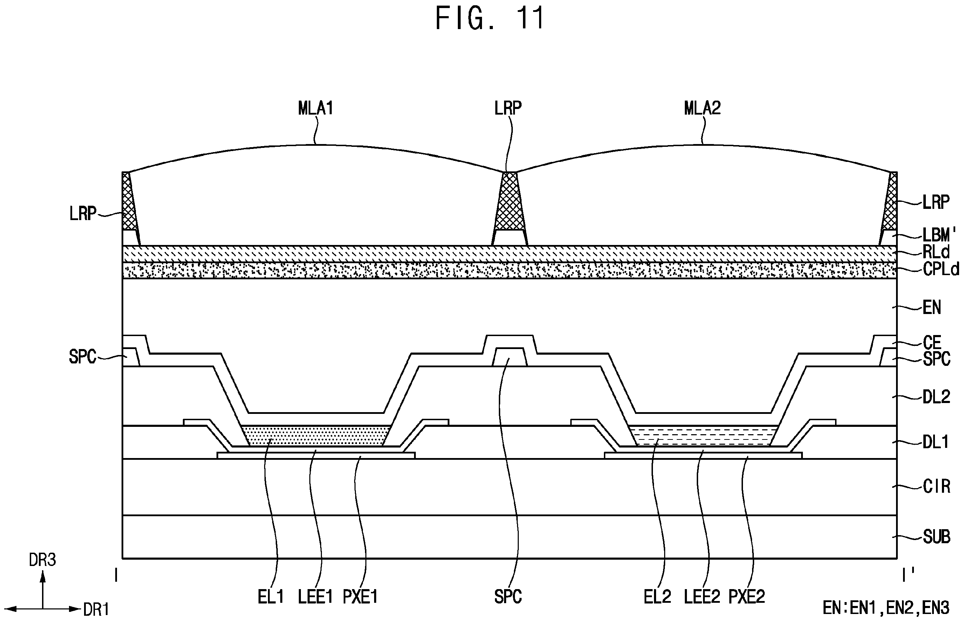

FIG. 11 is a schematic cross-sectional view of a display device according to a fifth embodiment of the disclosure. Descriptions of overlapping contents with those described with reference to FIGS. 1 to 7 may be omitted.

Referring to FIG. 11, a low refractive index layer RLd may be disposed on a capping layer CPLd, and a light blocking pattern LBM' including a light blocking material may be disposed between the low refractive index layer RLd and the bank LRP. The light-blocking pattern LBM' may overlap the bank LRP.

The light-blocking pattern LBM' may block the light emitted from the first light emitting layer EL1 and passing through the low refractive layer RLd that proceeds to the second lens unit MI,A2 and/or the light emitted from the second light emitting layer EL2 and passing through the low refractive layer RLd that proceeds to the first lens portion MLA1. Accordingly, the display defect may not occur.

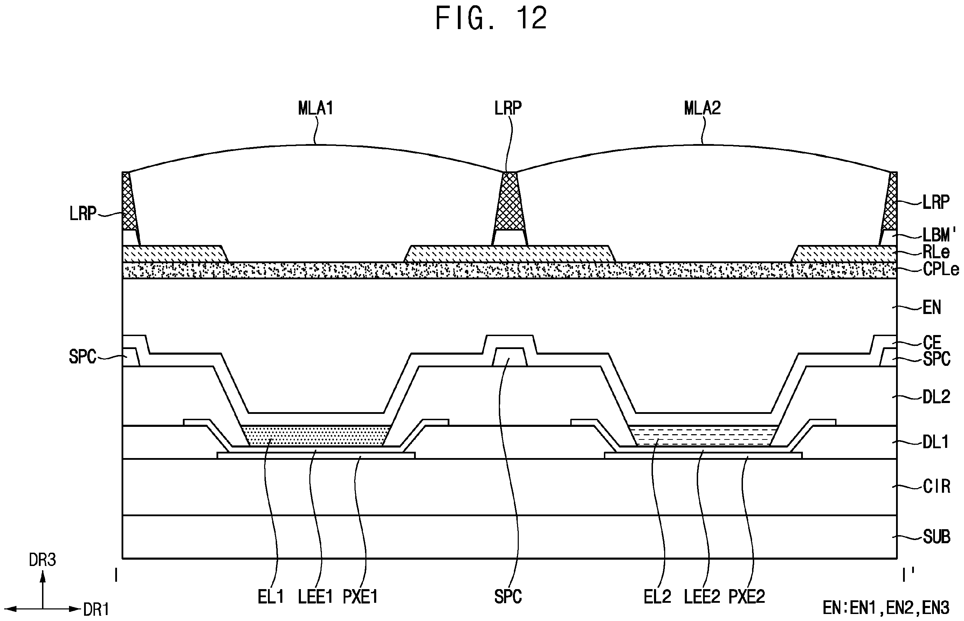

FIG. 12 is a schematic cross-sectional view of a display device according to a sixth embodiment of the disclosure. Descriptions of overlapping contents with those described with reference to FIGS. 1 to 7 may be omitted.

Referring to FIG. 12, a low refractive index layer RLe may be disposed on the capping layer CPLe, and a light blocking pattern LBM' including a light blocking material may be disposed between the low refractive index layer RLe and the bank LRP. A first transmission opening corresponding to the first pixel area PO1 and a second transmission opening corresponding to the second pixel area PO2 may be defined in the low refractive index layer RLe.

Accordingly, light emitting efficiency may be improved, and at the same time, the display defect may not occur.

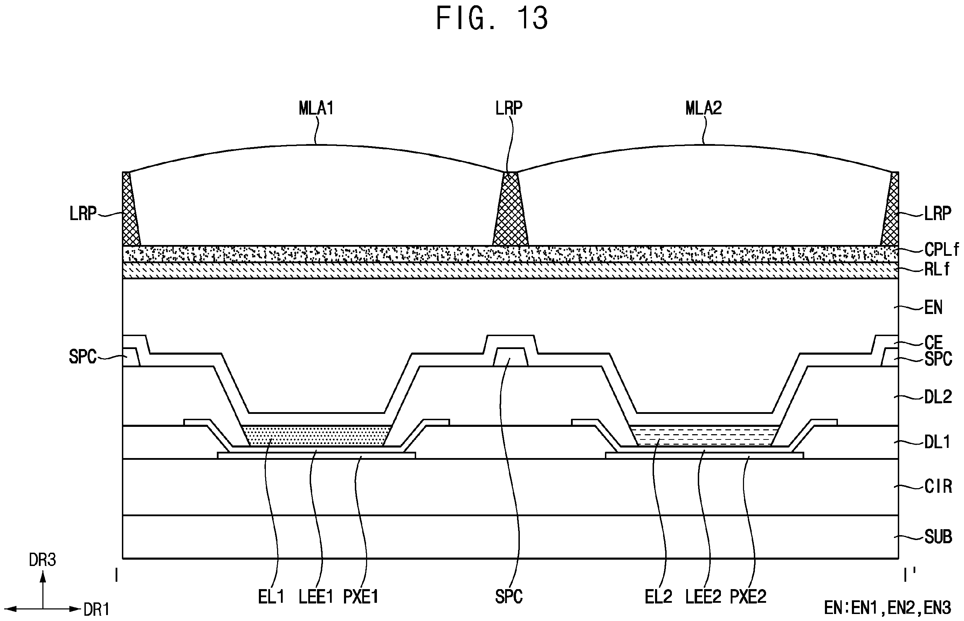

FIG. 13 is a schematic cross-sectional view of a display device according to a seventh embodiment of the disclosure. Descriptions of overlapping contents with those described with reference to FIGS. 1 to 7 may be omitted.

Referring to FIG. 13, a low refractive index layer RLf may be disposed on the encapsulation layer EN, and a capping layer CPLf may be disposed on the low refractive index layer RLf.

The refractive index of the low refractive index layer RLf may be lower than the refractive index of the third encapsulation layer EN3 in order to totally reflect light emitted from the light emitting layers EL1 and EL2 to have a relatively wide viewing angle and cause the display defects. For example, the refractive index ($N_{RL}$) of the low refractive index layer RLf may be smaller than the refractive index (NEN3) of the third encapsulation layer EN3, and at the same time, a difference between the refractive index ($N_{RL}$) of the low refractive index layer RLf and the refractive index (NEN3) of the third encapsulation layer EN3 may be about 0.1 or less. As another example, the refractive index ($N_{RL}$) of the low refractive index layer RLf and the refractive index (NEN3) of the third encapsulation layer EN3 may satisfy Equation 1 below.

$$[\text{Equation } 1]$$

$$N_{RL} \leq N_{NE3} \cdot \sin 62.5^\circ$$

The disclosure can be applied to various display devices. For example, the disclosure is applicable to various display devices such as display devices for vehicles, ships and aircraft, portable communication devices, display devices for exhibition or information transmission, medical display devices, and the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the disclosure. Accordingly, all such modifications are intended to be included within the scope of the disclosure. Therefore, it is to be understood that the foregoing is illustrative of various embodiments and is not to be construed as limited to the specific embodiments disclosed, and that modifications to the disclosed embodiments, as well as other embodiments, are intended to be included within the scope of the disclosure.

**Claims**

1.   A display device, comprising:

a plurality of pixel electrodes (PXE1, PXE2) spaced apart from each other;
a first definition layer (DL1) defining a plurality of reflective openings (RO1, RO2, RO3, RO4) exposing a first area of each of the plurality of pixel electrodes (PXE1, PXE2);
a plurality of reflective electrodes (LEE1, LEE2) disposed on the first area of each of the plurality of pixel electrodes (PXE1, PXE2), extending from the first area of each of the plurality of pixel electrodes (PXE1, PXE2) to the first definition layer (DL1), and spaced apart from each other;
a second definition layer (DL2) disposed on the first definition layer (DL1) and defining a plurality of pixel openings (PO1, PO2, PO3, PO4) exposing a second area of each of the plurality of reflective electrodes (LEE1, LEE2);
a plurality of light emitting layers (EL1, EL2) disposed on the second area of each of the plurality of reflective electrodes (LEE1, LEE2) within the plurality of pixel openings (PO1, PO2, PO3, PO4);
a common electrode (CE) overlapping the plurality of light emitting layers (EL1, EL2) and the second definition layer (DL2) in a plan view;
an encapsulation layer (EN) overlapping the common electrode (CE) in the plan view;
a capping layer (CPL) disposed on the encapsulation layer (EN); and
a low refractive index layer (RL) disposed on the capping layer (CPL).

2.   The display device of claim 1, further comprising:

a plurality of lens portions (MLA1, MLA2) disposed on the low refractive index layer (RL) and overlapping the plurality of reflective openings (RO1, RO2, RO3, RO4) in the plan view; and
a bank (LRP) disposed on the low refractive index layer (RL) and partitioning the plurality of lens portions (MLA1, MLA2).

3.   The display device of claim 2, wherein an upper surface of each of the plurality of lens portions (MLA1, MLA2) has a convex curved shape in a direction from the encapsulation layer (EN) toward the low refractive index layer (RL).

4.   The display device of claim 2 or 3, wherein the bank (LRP) is spaced apart from each of the plurality of reflective openings (RO1, RO2, RO3, RO4) and the plurality of pixel openings (PO1, PO2, PO3, PO4) in the plan view.

5.   The display device of any one of claims 2 to 4, wherein

a cross-sectional width of the bank (LRP) gradually decreases in a direction away from an upper surface of the low refractive index layer (RL); and/or
a contact angle between a side surface of the bank (LRP) and the upper surface of the low refractive index layer (RL) is in a range of about 45 degrees to about 90 degrees.

6.   The display device of any one of claims 2 to 5, further comprising:
a light blocking pattern (LBM) disposed on the encapsulation layer (EN), overlapping the bank (LRP) in the plan view, and including a light blocking material.

7.   The display device of any one of the preceding claims, wherein the low refractive index layer (RL) defines a plurality of transmission openings corresponding to the plurality of pixel openings (PO1, PO2, PO3, PO4).

8.   A display device, comprising:

a plurality of pixel electrodes (PXE1, PXE2) spaced apart from each other;
a first definition layer (DL1) defining a plurality of reflective openings (RO1, RO2, RO3, RO4) opening a first area of each of the plurality of pixel electrodes (PXE1, PXE2);
a plurality of reflective electrodes (LEE1, LEE2) disposed on the first area of each of the plurality of pixel electrodes (PXE1, PXE2), extending from the first area of each of the plurality of pixel electrodes (PXE1, PXE2) to the first definition layer (DL1), and spaced apart from each other;
a second definition layer (DL2) disposed on the first definition layer (DL1) and defining a plurality of pixel openings (PO1, PO2, PO3, PO4) opening a second area of each of the plurality of reflective electrodes (LEE1, LEE2);

a plurality of light emitting layers (EL1, EL2) disposed on the second area of each of the plurality of reflective electrodes (LEE1, LEE2) within the plurality of pixel openings (PO1, PO2, PO3, PO4);

a common electrode (CE) overlapping the plurality of light emitting layers (EL1, EL2) and the second definition layer (DL2) in a plan view;

an encapsulation layer (EN) overlapping the common electrode (CE) in the plan view; and

a low refractive index layer (RL) disposed on the encapsulation layer (EN).

9. The display device of claim 8, wherein the encapsulation layer (EN) includes:

a first encapsulation layer (EN1) overlapping the common electrode (CE) in the plan view and including an inorganic insulating material;

a second encapsulation layer (EN2) overlapping the first encapsulation layer (EN1) in the plan view and including an organic insulating material; and

a third encapsulation layer (EN3) overlapping the second encapsulation layer (EN2) in the plan view and including an inorganic insulating material.

10. The display device of claim 9, wherein a refractive index of the low refractive index layer (RL) is lower than a refractive index of the third encapsulation layer (EN3).

11. The display device of claim 10, wherein the refractive index ($N_{RL}$) of the low refractive index layer (RL) and the refractive index ($N_{NE3}$) of the third encapsulation layer (EN3) satisfy the equation $0 < N_{NE3} - N_{RL} \leq 0.1$.

12. The display device of any one of claims 8 to 11, further comprising:
a capping layer (CPL) disposed on the low refractive index layer (RL).

13. The display device of claim 12, further comprising:

a plurality of lens portions (MLA1, MLA2) disposed on the capping layer (CPL) and overlapping the plurality of reflective openings (RO1, RO2, RO3, RO4) in the plan view; and

a bank (LRP) disposed on the capping layer (CPL) and partitioning the plurality of lens portions (MLA1, MLA2).

14. The display device of claim 1, wherein:

a pixel electrode (PXE1, PXE2) includes:

a first pixel electrode (PXE1); and
a second pixel electrode (PXE2) spaced apart from the first pixel electrode (PXE1);

the first definition layer (DL1) defines a first reflective opening (RO1) exposing a first area of the first pixel electrode (PXE1) and a second reflective opening (RO2) exposing a first area of the second pixel electrode (PXE2);

a reflective electrode (LEE1, LEE2) includes:

a first reflective electrode (LEE1) disposed on the first area of the first pixel electrode (PXE1); and

a second reflective electrode (LEE2) disposed on the first area of the second pixel electrode (PXE2);

the second definition layer (DL2) defines a first pixel opening (OP1) exposing a second area of the first reflective electrode (LEE1) and a second pixel opening (OP2) exposing a second area of the second reflective electrode (LEE2); and

the light emitting layer (EL1, EL2) includes:
a first light emitting layer (EL1) disposed on the second area of the first reflective electrode (LEE1); and

a second light emitting layer (EL2) disposed on the second area of the second reflective electrode (LEE2).

15. The display device of claim 14, wherein

an area of the first reflective opening (RO1) is greater than an area of the first pixel opening (OP1) in a plan view, and

an area of the second reflective opening (RO2) is greater than an area of the second pixel opening (OP2) in the plan view.

16. The display device of claim 14 or 15, wherein

the first reflective electrode (LEE1) further extends from on the first area of the first pixel electrode (PXE1) to on the first definition layer (DL1) adjacent to the first area of the first pixel electrode (PXE1) to define a first extension portion,

the second reflective electrode (LEE2) further extends from on the first area of the second pixel electrode (PXE2) to on the first definition layer (DL1) adjacent to the first area of the second pixel electrode (PXE2) to define a second extension portion, and

the first reflective electrode (LEE1) and the second reflective electrode (LEE2) are spaced apart from each other.

**17.** The display device of any one of claims 14 to 16, wherein,

a first extension portion surrounds the first reflective opening (RO1) in the plan view, and a second extension portion surrounds the second reflective opening (RO2) in the plan view.

**18.** The display device of claim 17, wherein,

a level of an edge of the first extension portion surrounding the first reflective opening (RO1) is higher than a level of an upper surface of the first light emitting layer (EL1) in a cross-sectional view, and a level of an edge of the second extension portion surrounding the second reflective opening (RO2) is higher than a level of an upper surface of the second light emitting layer (EL2) in the cross-sectional view.

**19.** The display device of claim 17 or 18, wherein,

the second definition layer (DL2) is disposed between the first extension portion and the first light emitting layer (EL1), and between the second extension portion and the second light emitting layer (EL2), and the second definition layer (DL2) includes a transparent organic material.

**20.** The display device of any one of claims 14 to 19, further comprising:
a spacer (SPC) disposed between the first pixel opening (OP1) and the second pixel opening (OP2) in a plan view, and disposed between the second definition layer (DL2) and the common electrode (CE) in a cross-sectional view.

**21.** The display device of claim 20, wherein the spacer (SPC) includes a light blocking material.

**22.** The display device of any one of claims 14 to 21, further comprising:

a lens portion (MLA1, MLA2) disposed on the low refractive index layer (RL) and including:

a first lens portion (MLA1) overlapping the first reflective opening (RO1) in the plan view; and a second lens portion (MLA2) overlapping the second reflective opening (RO2) in the plan view; and

a bank (LRP) disposed on the low refractive index layer (RL) and partitioning the first lens portion (MLA1) and the second lens portion (MLA2).

**23.** The display device of claim 22, wherein,

an area of the first lens portion (MLA1) is greater than an area of the first reflective opening (RO1) in the plan view, and an area of the second lens portion (MLA2) is greater than an area of the second reflective opening (RO2) in the plan view.

**24.** The display device of claim 1 or 14, wherein a refractive index of the low refractive index layer (RL) is lower than a refractive index of the capping layer (CPL).

**25.** The display device of claim 24, wherein the refractive index, $N_{RL}$, of the low refractive index layer (RL) and the refractive index, $N_{CPL}$, of the capping layer (CPL) satisfy the equation $0 < N_{CPL} - N_{RL}$ ^0.1.

# FIG. 1

DA

PXA1 ⋮ PXA2

R01
P01

R02
P02

PXA

···

···

R03
P03

R04
P04

PXA3 ⋮ PXA4

PXA : PXA1 , PXA2 , PXA3 , PXA4
R0 : R01 , R02 , R03 , R04
P0 : P01 , P02 , P03 , P04

DR2

DR1

# FIG. 2

# FIG. 3

PXA1

PXA2

DA'

DR2

DR1

# FIG. 4

MLA1

LRP

L_F3

L_F4    L_F4

L_F2    L_F1    L_F2

MLA2

LRP    LRP

RL

CPL

EN

CE

SPC    SPC

DL2

DL1

CIR

SUB

DR3

DR1

I    I'

EL1  LEE1  PXE1        SPC        EL2  LEE2  PXE2

EN:EN1,EN2,EN3

EP 4 383 986 A1

# FIG. 5

Labels: LRP, RL, CPL, EN, CE, SPC, DL2, DL1, CIR, SUB

EN : EN1 , EN2 , EN3

MLA2, MLA1, LRP, L_S1, L_S2

EL2 LEE2 PXE2, SPC, EL1 LEE1 PXE1

DR3, DR1

# FIG. 6

# FIG. 7

EP 4 383 986 A1

MLA1    LRP    MLA2

LRP

L_F4'

L_S3'

LRP — RL

CPL

EN

L_S3

L_F4 — CE

SPC — SPC

DL2

DL1

CIR

SUB

DR3
DR1

I    I'

EL1  LEE1  PXE1    SPC    EL2  LEE2  PXE2

EN : EN1, EN2, EN3

# FIG. 8

MLA1  LRP  MLA2

LRP  LRP

RLa

CPLa

EN

SPC  CE
SPC

DL2

DL1

CIR

SUB

EL1  LEE1  PXE1  SPC  EL2  LEE2  PXE2

DR3
DR1

EN:EN1,EN2,EN3

EP 4 383 986 A1

FIG. 9

EN：EN1，EN2，EN3

## FIG. 10

EP 4 383 986 A1

MLA1  LRP  MLA2

LRP — LRP

RLc
LBM
CPLc

EN

CE
SPC

DL2

DL1

CIR

SUB

SPC

SPC

DR3
DR1

I  I'

EL1 LEE1 PXE1  SPC  EL2 LEE2 PXE2

EN:EN1,EN2,EN3

# FIG. 11

FIG. 12

MLA1　　　LRP　　　MLA2

LRP

LRP

LBM'

RLe

CPLe

EN

CE

SPC

SPC

DL2

DL1

CIR

SUB

DR3

DR1

EL1 LEE1 PXE1　　　SPC　　　EL2 LEE2 PXE2

EN：EN1，EN2，EN3

EP 4 383 986 A1

# FIG. 13

EP 4 383 986 A1

Labels: MLA1, LRP, MLA2, LRP, CPLf, RLf, EN, CE, SPC, DL2, DL1, CIR, SUB

SPC, EL1 LEE1 PXE1, SPC, EL2 LEE2 PXE2

DR3, DR1

I, I'

EN : EN1, EN2, EN3

Europäisches
Patentamt

European
Patent Office

Office européen
des brevets

# EUROPEAN SEARCH REPORT

Application Number

EP 23 21 3976

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 3 910 681 A1 (SAMSUNG DISPLAY CO LTD [KR]) 17 November 2021 (2021-11-17) | 1-17, 19-25 | INV. H10K59/80 H10K59/122 |
| A | * paragraphs [0070], [0083] – [0100], [0111], [0114]; figures 1,4B * | 18 | |
| Y | WO 2022/025365 A1 (SAMSUNG DISPLAY CO LTD [KR]) 3 February 2022 (2022-02-03) | 1-17, 19-25 | |
| A | * paragraphs [0187], [0188], [0226], [0289]; figures 5,11 * | 18 | |

TECHNICAL FIELDS
SEARCHED (IPC)

H10K

The present search report has been drawn up for all claims

| Place of search | Date of completion of the search | Examiner |
|---|---|---|
| The Hague | 23 April 2024 | Welter, Steve |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 3976

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2024

| Patent document cited in search report | | Publication date | Patent family member(s) | | Publication date |
|---|---|---|---|---|---|
| EP 3910681 | A1 | 17-11-2021 | CN 113675238 | A | 19-11-2021 |
| | | | EP 3910681 | A1 | 17-11-2021 |
| | | | KR 20210142054 | A | 24-11-2021 |
| | | | US 2021359048 | A1 | 18-11-2021 |
| WO 2022025365 | A1 | 03-02-2022 | CN 116134987 | A | 16-05-2023 |
| | | | EP 4191695 | A1 | 07-06-2023 |
| | | | KR 20220014426 | A | 07-02-2022 |
| | | | US 2023284512 | A1 | 07-09-2023 |
| | | | WO 2022025365 | A1 | 03-02-2022 |

EPO FORM P0459

For more details about this annex : see Official Journal of the European Patent Office, No. 12/82